Europäisches Patentamt

European Patent Office

Office européen des brevets

(19)

(11) Veröffentlichungsnummer: **0 309 693 B1**

(12) **EUROPÄISCHE PATENTSCHRIFT**

(45) Veröffentlichungstag der Patentschrift: **10.11.93**

(51) Int. Cl.5: **H03F 1/30**, H03F 1/32

(21) Anmeldenummer: **88112851.6**

(22) Anmeldetag: **06.08.88**

(54) **Schaltungsanordnung zur automatischen Einstellung des Ruhestroms in einer Gegentaktendstufe.**

(30) Priorität: **30.09.87 DE 3732915**

(43) Veröffentlichungstag der Anmeldung:
**05.04.89 Patentblatt  89/14**

(45) Bekanntmachung des Hinweises auf die
Patenterteilung:
**10.11.93 Patentblatt  93/45**

(84) Benannte Vertragsstaaten:
**AT BE CH DE ES FR GB IT LI LU NL SE**

(56) Entgegenhaltungen:
**US-A- 3 434 066**
**US-A- 4 207 475**
**US-A- 4 263 563**
**US-A- 4 573 021**

(73) Patentinhaber: **Deutsche Thomson-Brandt
GmbH
Hermann-Schwer-Strasse 3
Postfach 1307
D-78003 Villingen-Schwenningen(DE)**

(72) Erfinder: **Schmitz, Friedrich
Sebastian-Kneipp-Strasse 24
D-7730 Villingen-Schwenningen(DE)**

EP 0 309 693 B1

## Beschreibung

Die Erfindung geht aus von einer Schaltungsanordnung zur automatischen Einstellung des Ruhestromes in einer transformatorlosen transistorisierten Gegentaktendstufe, an deren Ausgang eine Lastimpedanz nach Bezugspotential geschaltet ist, sowie mit mindestens einem Fühlelement zur Messung des in der Gegentaktendstufe fliessenden Ruhestromes, wobei in jedem Zweig der Gegentaktendstufe je ein Fühlelement vorgesehen ist, an welchem je eine gegen das Bezugspotential gemessene Spannung abgreifbar ist, die auf je einen Eingang einer Differenzverstärkerstufe geschaltet sind, deren Ausgang an den einen Eingang einer Komparatorschaltung geschaltet ist, deren anderer Eingang auf einem Referenzpotential liegt, und daß der Ausgang der Komparatorschaltung einen elektronischen Schalter in der Weise steuert, daß er einen elektrischen Speicher auflädt, dessen Ladespannung den Ruhestrom der Gegentaktendstufe über einen Regeltransistor derart regelt, daß der durch die Fühlelemente gemessene dem Ruhestromwert proportionale Spannungswert mit dem Referenzpotential übereinstimmt. Eine derartige Schaltung ist aus der DE-A-36 32 076 bekannt. Siehe auch die Ruhestromregelung nach der US-A-4 207 475.

Die in ersterer Patentanmeldung beschriebene Schaltungsanordnung besitzt noch eine teilweise Frequenzabhängigkeit der automatischen Ruhestromregelung.

Der Erfindung liegt die Aufgabe zugrunde, diese Frequenzabhängigkeit zu beseitigen. Diese Aufgabe wird durch die im Patentanspruch 1 angegebene Erfindung gelöst. Weitere vorteilhafte Ausgestaltungen der Erfindung sind in den Unteransprüchen angegeben.

Nachstehend wird die Erfindung mit Hilfe der Zeichnung beschrieben.

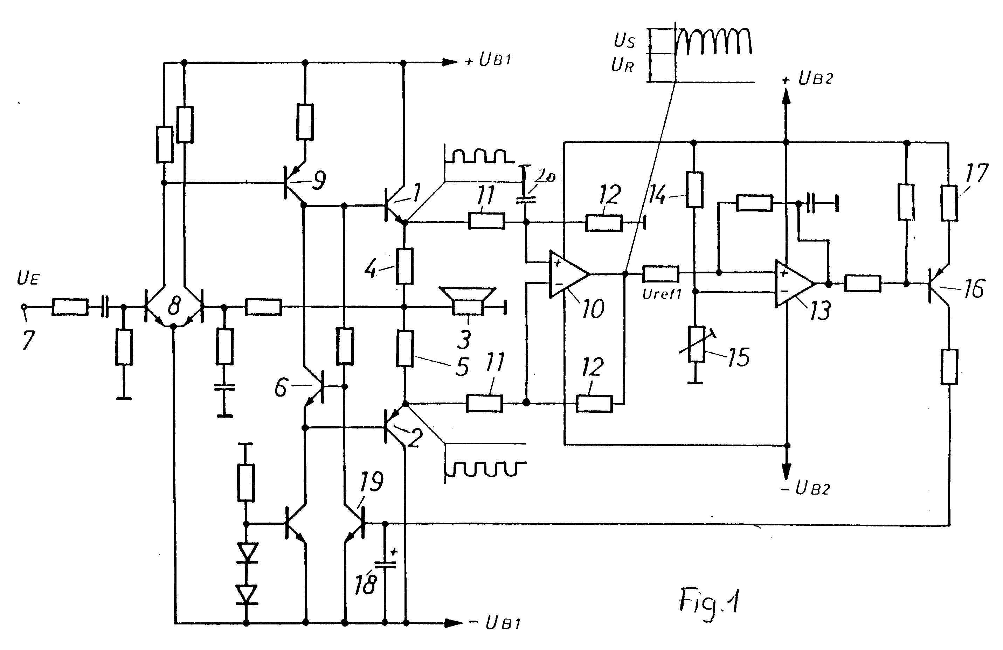

Figur 1    zeigt eine sich auf die Erfindung beziehende Schaltungsanordnung

Figur 2    zeigt Spannungsdiagramme zur Erläuterung der Auswirkung der Erfindung.

Zunächst wird nochmals auf die in der DE-A-36 32 076 beschriebene Schaltung eingegangen, von der die Erfindung ausgeht, wobei nur die wesentlichen Teile der Figur übernommen wurden.Es handelt sich bei der Schaltungsanordnung um den Aufbau einer bekannten Gegentaktendstufe mit den komplementären mit ihren Emittern zusammengeschalteten Endtransistoren 1 und 2, deren Kollektoren mit dem Betriebsspannungspotential +UB1 bzw. -UB1 verbunden sind. Die Lastimpedanz 3, z.B. in Form eines Lautsprechers, ist an den Ausgang der Gegentaktendstufe angeschlossen. Das andere Ende der Lastimpedanz ist mit einem Bezugspotential z.B. Masse verbunden. Zwecks Einstellung des in der Gegentaktendstufe fliessenden Ruhestromes dient ein zwischen die Basen der Endtransistoren 1 und 2 eingeschalteter Transistor 6. Über den Anschluß 7 wird das Eingangssignal UE zugeführt, welches über den Vorverstärker 8 und den Treibertransistor 9 die Gegentaktendstufe 1, 2 ansteuert. An den Widerständen 4 und 5 sind gegen das Bezugspotential gemessene Spannungen abgreifbar. Die an dem Widerstand 4 abgegriffene Spannung, die durch den Ruhestrom und den diesem überlagerten durch die Lastimpedanz 3 fliessenden Laststrom gebildet wird, wird dem nichtinvertierenden Eingang einer Differenzverstärkerstufe 10 und die am Widerstand 5 abgegriffene Spannung dem invertierenden Eingang der Differenzverstärkerstufe 10 zugeführt. Am Ausgang der Differenzverstärkerstufe 10 entsteht ein Signal, wie es in der Figur eingezeichnet ist. Es setzt sich zusammen aus dem Wert UR, der dem Ruhestrom, und dem Wert US, der dem Signalstrom entspricht.

Durch die Zuführung des negativen Signalanteils an den invertierenden Eingang der Differenzverstärkerstufe 10 erscheint dieser am Ausgang um 180° phasengedreht. Da die Versorgungsspannung UB2 für die Differenzverstärkerstufe10 meistens kleiner ist als die Versorgungsspannung UB1 für die Gegentaktendstufe, muß die der Differenzverstärkerstufe 10 zugeführte Signalspannung um einen Teilungsfaktor heruntgergesetzt werden, der dem Verhältnis der Widerstandswerte der Widerstände (R11 + R12) entspricht. Die Differenzverstärkerstufe 10 besitzt einen Verstärkungsgrad V = R12/R11. Die Ausgangsspannung wird dem einen Eingang einer Komparatorschaltung 13 zugeleitet, deren anderer Eingang auf ein Rererenzpotential $U_{ref}$ gelegt ist, das mit Hilfe des an die Betriebsspannungsquelle UB2 gelegten Spannungsteilers aus den Widerständen 14 und 15 gebildet wird. Wenn der am Plus-Eingang des Komparators 13 anliegende Spannungswert das am Minus-Eingang anliegende Referenzpotential $U_{ref}$ unterschreitet, geht der Ausgang des Komparators 13 auf Bezugspotential. Der Komparator 13 besitzt einen Open-Kollektor-Ausgang, der entweder Bezugspotential oder die Betriebsspannung UB2 annimmt. Wenn der Ausgang auf das Bezugspotential absinkt, wird ein elektronischer Schalter in Form eines Transistors 16 durchlässig, so daß die Betrisspannung UB2 über den Widerstand 17 einen elektrischen Speicher in Form eines Kondensators 18 auflädt, der über einen Regeltransistor 19 den Transistor 6 derart beeinflußt, daß der Ruhestrom solange ansteigt, bis der dem Plus-Eingang des Komparators 13 zugeführte Spannungswert dem Referenzpotential $U_{ref}$ entspricht. Das Referenzpotential $U_{ref}$ ist derart eingestellt, daß es dem Spannungsabfall an den Widerständen 4 und 5 entspricht, der dem gewünschten Ruhestrom durch die Gegentaktendstufe proportional ist. Wenn dieser Spannungswert erreicht ist, wird durch das am Ausgang des Komparators 13 entstehende Potential der Transistor 16 gesperrt. Durch die Schaltung erfolgt eine Nachladung des Kondensators 18 nur während der Nulldurchgänge des Eingangssignals UE, zu Zeiten, wenn der tatsächliche Ruhestrom fliesst.

Es gibt Endtransistoren, die bei Aussteuerung mit Signalen höherer Frequenz und bei großen Lastströmen einen Querstrom durch die Endstufe leiten, wenn ihre Grenzfrequenz zu klein ist. Sie sind dann bei der wechselweisen Abschaltung zu träge, so daß dieser zusätzliche Querstrom fliessen kann. Diesen Querstrom interpretiert die weiter oben beschriebene Schaltung zur automatischen Ruhestromregelung als Ruhestrom, so daß sie versucht diesen abzuregeln, bis der Gesamtstrom wieder dem vorgegebenen Referenzwert entspricht. Dadurch ist der erforderliche Ruhestrom jedoch zu gering, so daß bei hohen Freqenzen und großen Lastströmen Übernahmeverzerrungen entstehen können. Um diesem Fall zu vermeiden, könnte man den Ruhestrom grundsätzlich um den Faktor 3 - 4 größer wählen und erhielte damit einen sicheren Abstand zu den Übernahmeverzerrungen. Dieses erhöht jedoch die Ruheverlustleistung erheblich. Das bedeutet auch größere Verlustwärme, die wiederum über größere Kühlkörper abzuführen ist.

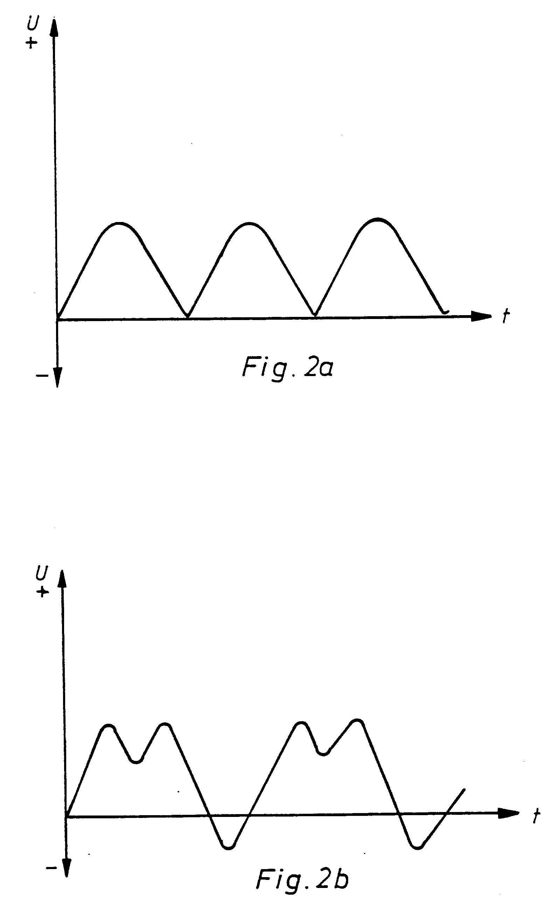

Zur Beseitigung der frequenzabhängigen Ruhestromregelung, die ab ca. 8 kHz einen zu kleinen Ruhestrom liefert, wird an einen, z.B. den nicht invertierenden Eingang des Differenzverstärkers 10 ein phasendrehendes Glied angeschaltet. In der Figur ist dies z.B. ein zwischen den Eingang und Bezugspotential geschalteter Kondensator 20. Der Widerstand 11 in der Größe von z.B. 20 kOhm und der Kondensator 20 in der Größe von z.B. 10pF verschieben die Phase des Eingangssignals um ca. ein Grad. Durch diese geringfügige Phasenverschiebung wird absichtlich die Gleichtaktunterdrückung bei hohen Frequenzen verschlechtert. Ohne das phasendrehende Glied ergibt sich am Ausgang des Differenzverstärkers 10 die Spannung nach Figur 2a. Der Ruhestrom stellt sich automatisch so ein, daß die negativen Spitzen der Spannung dem Referenzwert des Komparators 13 entsprechen. Durch die schlechte Gleichtaktunterdrückung infolge der absichtlich eingeführten Phasenverschiebung des einen Eingangssignals am Differenzverstärker 10 ergibt sich die Kurve nach Figur 2b. Man sieht, daß diese Kurve teilweise unterhalb der Nullinie liegt. Die automatische Ruhestromregelung ist schaltungsbedingt bestrebt, sich immer auf den Referenzwert einzustellen. Die Schaltung sieht jedoch zeitweise einen zu niedrigen Spannungswert und erhöht entsprechend die Lademenge für den Kondensator 18. Anstelle eines Kondensators kann in die Eingangsleitung des Differenzverstärkers 10 auch eine Induktivität in Serie zum Widerstand 11 in der Größe von ca. 1 mH mit gleicher Wirkung gelegt werden.

**Patentansprüche**

1.  Schaltungsanordnung zur automatischen Einstellung des Ruhestromes in einer transformatorlosen transistorisierten Gegentaktendstufe (1,2), an deren Ausgang eine Lastimpedanz (3) nach Bezugspotential geschaltet ist, sowie mit mindestens einem Fühlelement (4,5) zur Messung des in der Gegentaktendstufe fliessenden Ruhestromes, wobei in jedem Zweig der Gegentaktendstufe je ein Fühlelement (4,5) vorgesehen ist, an welchem je eine gegen das Bezugspotential gemessene Spannung abgreifbar ist, die auf je einen Eingang einer Differenzverstärkerstufe (10) geschaltet sind, deren Ausgang an den einen Eingang einer Komparatorschaltung (13) geschaltet ist, deren anderer Eingang auf einem Referenzpotential liegt, und daß der Ausgang der Komparatorschaltung (13) einen elektronischen Schalter (16) in der Weise steuert, daß er einen elektrischen Speicher (18) auflädt, dessen Ladespannung den Ruhestrom der Gegentaktendstufe (1,2) über einen Regeltransistor (19) derart regelt, daß der durch die Fühlelemente (4,5) gemessene dem Ruhestromwert proportionale Spannungswert mit dem Referenzpotential übereinstimmt, **dadurch gekennzeichnet**, daß an einen der beiden Eingänge des Differenzverstärkers (10) ein phasendrehendes Element (20) geschaltet ist, wodurch die Ausgangsspannung der Differenzverstärkerstufe (10) bei höheren Frequenzen abgesenkt wird und Ruhestrom zur Kompensatien von in den Endstufentransistoren (1,2) fließenden Querströmen angehoben wird.

2.  Schaltungsanordnung nach Anspruch 1, **dadurch gekennzeichnet**, daß an den invertierenden oder nicht invertierenden Eingang des Differenzverstärkers (10) ein Kondensator (20) nach Bezugspotential geschaltet ist.

3.  Schaltungsanordnung nach Anspruch 2, **dadurch gekennzeichnet**, daß der Kondensator in der Größenordnung von 10 pF liegt.

4.  Schaltungsanordnung nach Anspruch 1, **dadurch gekennzeichnet**, daß in die Zuleitung zum invertierenden oder nicht invertierenden Eingang des Differenzverstärkers (10) eine Induktivität geschaltet ist.

5. Schaltungsanordnung nach Anspruch 4, **dadurch gekennzeichnet**, daß der Wert der Induktivität in der Größe von 1 mH liegt.

## Claims

1. Circuit arrangement for automatically adjusting the quiescent current in a transformerless transistorised push pull output stage (1, 2) at whose output a load impedance (3) is connected to a datum potential and including at least one sensing element (4, 5) for measuring the quiescent current flowing in the push pull output stage wherein there is provided in each branch of the push pull output stage a respective sensing element (4, 5) from each of which a voltage measured against the datum potential can be tapped off, which voltages are each connected to a respective input of a differential amplifier stage (10) whose output is connected to the one input of a comparator circuit (13) whose other input is at a reference potential, and that the output of the comparator circuit (13) controls an electronic switch (16) in a manner such that it charges an electrical store (18) whose charging voltage regulates the quiescent current of the push pull output stage (1, 2) via a regulating transistor (19) in such a way that the voltage value which is proportional to the quiescent current and which is measured by the sensing elements (4, 5) is equal to the reference potential, characterised in that, a phase rotating element (20) is connected to one of the two inputs of the differential amplifier (10) whereby the output voltage of the differential amplifier stage (10) is reduced at higher frequencies and the quiescent current is boosted for the compensation of the shunt currents flowing in the output stage transistors (1, 2).

2. Circuit arrangement in accordance with Claim 1, characterised in that, a capacitor (20) is connected to the datum potential at the inverting or non-inverting input of the differential amplifier (10).

3. Circuit arrangement in accordance with Claim 2, characterised in that, the capacitor is in the order of magnitude of 10 pF.

4. Circuit arrangement in accordance with Claim 1, characterised in that, an inductance is connected in the lead to the inverting or non-inverting input of the differential amplifier (10).

5. Circuit arrangement in accordance with Claim 4, characterised in that, the value of the inductance has a magnitude of 1 mH.

## Revendications

1. Circuit pour le réglage automatique du courant de repos dans un étage de sortie push-pull (1, 2) transistorisé sans transformateur à la sortie duquel une impédance de charge (3) est montée vers le potentiel de référence ainsi qu'avec au moins un élément capteur (4, 5) pour mesurer le courant de repos qui passe dans l'étage de sortie push-pull, un élément capteur (4, 5) étant prévu dans chaque branche de l'étage de sortie push-pull, élément sur lequel une tension mesurée par rapport au potentiel de référence peut respectivement être prélevée, ces éléments étant commutés chacun sur une entrée d'un étage amplificateur différenciateur (10) dont la sortie est commutée sur l'une des entrées d'un circuit comparateur (13) dont l'autre entrée se trouve sur un potentiel de référence et que la sortie du circuit comparateur (13) commande un commutateur électronique (16) de telle manière qu'elle charge un accumulateur électrique (18) dont la tension de charge règle le courant de repos de l'étage de sortie push-pull (1, 2) par l'intermédiaire d'un transistor de réglage (19) de telle manière que la valeur de la tension, qui est proportionnelle à la valeur du courant de repos, qui est mesurée par les éléments capteurs (4, 5) coïncide avec le potentiel de référence, **caractérisé en ce** qu'un élément de rotation de phase (20) est monté sur l'une des deux entrées de l'amplificateur différenciateur (10), ce par quoi la tension de sortie de l'étage amplificateur différenciateur (10) est abaissée lors de fréquences plus élevées et le courant de repos est augmenté pour compenser les composantes transversales de courant qui passent dans les transistors de l'étage de sortie (1, 2).

2. Circuit selon la revendication 1, **caractérisé en ce** qu'un condensateur (20) est monté vers le potentiel de référence à l'entrée d'inversion ou de non inversion de l'amplificateur différenciateur (10).

3. Circuit selon la revendication 2, **caractérisé en ce** que le condensateur est de l'ordre de grandeur de 10 pF.

4. Circuit selon la revendication 1, **caractérisé en ce** qu'une inductance est montée dans la conduite d'amenée à l'entrée d'inversion ou de non inversion de l'amplificateur différenciateur (10).

5. Circuit selon la revendication 4, **caractérisé en ce** que la valeur de l'inductance est de l'ordre d'1 mH.

Fig.1

EP 0 309 693 B1

Fig. 2a

Fig. 2b